# EUROPÄISCHE PATENTSCHRIFT

(11) **EP 2 754 729 B1**
(45) Veröffentlichungstag und Bekanntmachung des Hinweises auf die Patenterteilung: **03.06.2015**
(21) Anmeldenummer: 14001267.5
(22) Anmeldetag: 12.04.2011
(51) Int. Cl.: C23C 14/32, C23C 14/34, H01J 37/34, B22F 7/06, B22F 7/08

(54) **Beschichtungsquelle und Verfahren zu deren Herstellung**
Coating source and method for its preparation
Source de revêtement et son procédé de fabrication

(30) Priorität: 14.04.2010 AT 23910 U
(43) Veröffentlichungstag der Anmeldung: 16.07.2014
(62) Teilanmeldung aus: 11722273.7
(73) Patentinhaber: Plansee SE, 6600 Reutte (AT)
(72) Erfinder: Polcik, Peter, 6600 Reutte (AT); Polzer, Conrad Wilhelm, 71384 Weinstadt (DE); Perl, Matthias, 6675 Tannheim (AT); Schlichtherle, Stefan, 6632 Ehrwald (AT); Strauss, Georg, 6232 Münster (AT)

(56) Entgegenhaltungen:
- EP-A1- 1 744 347
- WO-A1-02/40735
- DE-A1- 4 329 155
- JP-A- 7 113 165
- JP-A- 2000 328 240

## Beschreibung

Die vorliegende Erfindung betrifft eine Beschichtungsquelle für die physikalische Dampfphasenabscheidung und ein Verfahren zur Herstellung einer derartigen Beschichtungsquelle.

In der Technik werden in großem Umfang Verfahren der physikalischen Dampfphasenabscheidung zur Herstellung verschiedenster Schichten eingesetzt. Die Anwendung reicht von der Herstellung von verschleißfesten und korrosionsbeständigen Beschichtungen für die unterschiedlichsten Substratmaterialien bis hin zur Herstellung geschichteter Materialverbunde, insbesondere in der Halbleiter- und Elektronikindustrie. Aufgrund dieses breiten Anwendungsspektrums müssen verschiedenartige Beschichtungsmaterialien abgeschieden werden.

Bei der physikalischen Dampfphasenabscheidung kommen dabei verschiedene Techniken zum Einsatz, wie z.B. Verdampfen, Kathodenzerstäubung (sputter deposition) oder Lichtbogenverdampfung (cathodic arc deposition bzw. Arc-Source-Verdampfungstechnik).

Bei dem Verfahren der Kathodenzerstäubung wird mittels eines Arbeitsgases, z.B. Argon, ein Plasma in einer Kammer erzeugt. Ionen des Arbeitsgases werden auf ein aus Beschichtungsmaterial gebildetes Target beschleunigt und schlagen dort Teilchen des Beschichtungsmaterials heraus, die in die Dampfphase übertreten und aus dieser auf einem zu beschichtenden Substrat abgeschieden werden. Es ist bekannt, bei dem Verfahren der Kathodenzerstäubung ein Magnetfeld über der aktiven Oberfläche des Targets auszubilden, um den Prozess zu unterstützen. Dabei erhöht das Magnetfeld die Plasmadichte in der Nähe der aktiven Oberfläche des Targets und führt somit zu einem vermehrten Abtrag des Beschichtungsmaterials. Ein derartiges Verfahren wird als Magnetron-Kathodenzerstäubung (magnetron sputter deposition) bezeichnet.

EP 1 744 347 A1 beschreibt ein Target für Magnetron-Kathodenzerstäubung, bei dem - mit dem Ziel eine Zerstäubung eines ferromagnetischen Beschichtungsmaterials zu ermöglichen - in einer Rückseite des Targets ein Magnet angeordnet ist, um das durch die aktive Oberfläche des Targets hindurchtretende Magnetfeld zu vergrößern. Es ist beschrieben, den Magneten in dem Target durch Einpressen oder durch Bonden mittels bekannter Bonding-Techniken in gebohrten Löchern anzuordnen.

Das Verfahren der Lichtbogenverdampfung unterscheidet sich grundsätzlich von dem zuvor beschriebenen Verfahren der Kathodenzerstäubung. Die Lichtbogenverdampfung kommt unter anderem bei Hartstoffbeschichtungen von Werkzeugen und Maschinenteilen und für Schichten im dekorativen Anwendungsbereich zum Einsatz. Bei der Lichtbogenverdampfung wird eine Bogenentladung ausgenutzt, die zwischen dem als Target bereitgestellten Beschichtungsmaterial als Kathode und einer Anode gezündet wird. Der resultierende Hochstrom-Niederspannungsbogen (im Folgenden Bogen) erzeugt sich selbst über die freien Ladungsträger der Kathode und einen höheren Partialdruck, sodass auch unter Hochvakuum eine Bogenentladung aufrecht erhalten werden kann. Je nach Ausgestaltung der verwendeten Technik bewegt sich die Position des Bogens entweder mehr oder weniger zufällig (sogenannte random-arc Technik) oder gesteuert (sogenannte steered-arc Technik) über die Oberfläche der Kathode, wobei auf sehr kleiner Fläche (in sogenannten Spots) ein hoher Energieeintrag in die Oberfläche des Targets erfolgt. Dieser hohe Energieeintrag führt lokal zu einem Verdampfen des Beschichtungsmaterials an der Oberfläche des Targets. Der Bereich eines Spots besteht dabei aus flüssigen Tröpfchen des Beschichtungsmaterials, Beschichtungsmaterialdampf und erzeugten Ionen des Beschichtungsmaterials. Das Target wird nur auf sehr kleinen Flächen in den schmelzflüssigen Zustand übergeführt und kann somit in jeder Lage als Verdampfungsquelle mit relativ hoher Beschichtungsrate betrieben werden. Die Ionisierung des Beschichtungsmaterial-Dampfes ist für die resultierenden Eigenschaften der auf dem zu beschichtenden Substrat abgeschiedenen Schicht aus Beschichtungsmaterial von großer Bedeutung. Bei Beschichtungsmaterialien mit hohem Dampfdruck liegen üblicherweise ca. 25 % der Dampfteilchen in ionisiertem Zustand vor und bei Beschichtungsmaterialien mit niedrigem Dampfdruck üblicherweise zwischen 50 % und 100 % der Dampfteilchen. Für ein reaktives Ionenplattieren sind somit keine zusätzlichen Ionisierungsvorrichtungen in der Anlage notwendig. Die grundlegenden Parameter bei der Technik der Lichtbogenverdampfung sind die Bogenspannung und der Bogenstrom, die von weiteren Parametern, wie insbesondere dem Material des Targets, einem vorhandenen Reaktivgas und dem gegebenen Arbeitsdruck, beeinflusst werden. Übliche Betriebsbedingungen bei der Lichtbogenverdampfung sind beispielsweise eine Bogenspannung zwischen 15 V und 30 V und ein Bogenstrom zwischen 50 A und 150 A.

Bei der Lichtbogenverdampfung bestimmt die Geschwindigkeit der Bewegung des Bogens auf der Oberfläche des Targets die Menge des in dem entsprechenden Spot aufgeschmolzenen Materials. Je kleiner diese Geschwindigkeit ist, desto größer ist die zu dem zu beschichtenden Substrat hin geschleuderte Menge an Beschichtungsmaterial aus dem Spot. Eine niedrige Geschwindigkeit führt somit zu unerwünschten Spritzern bzw. Makropartikeln in der auf dem Substrat aufwachsenden Schicht. Die erzielte Geschwindigkeit der Bewegung des Bogens hängt dabei von dem Beschichtungsmaterial des Targets ab. Eine reduzierte elektrische Leitfähigkeit des Beschichtungsmaterials führt zu einer Verringerung der Geschwindigkeit des Bogens. Wenn die Geschwindigkeit des Bogens auf der Oberfläche des Targets zu niedrig ist, d.h. eine zu lange Verweildauer auf einem Spot vorliegt, sind eine lokale thermische Überlastung des Targets und eine starke Verunreinigung der auf dem Substrat aufwachsenden Schicht mit unerwünschten Spritzern bzw. Makropartikeln die Folge. Es kann dabei auch zu einer vorzeitigen Unbrauchbarkeit des Targets aufgrund von makroskopischen Aufschmelzungen der Oberfläche kommen.

Die Geschwindigkeit der Position des Bogens und somit die Spotgröße können durch Magnetfelder beeinflusst werden. Je höher die Magnetfeldstärke ist, umso schneller bewegt sich der Bogen. Es ist bekannt in Anlagen für die Lichtbogenverdampfung hinter einer gekühlten Auflage für das Target Elektromagneten oder Permanentmagneten vorzusehen, um die Geschwindigkeit des Bogens zu beeinflussen.

DE 43 29 155 A1 beschreibt eine Magnetfeldkathode für

Bogenentladungsverdampfer mit einer Spulenanordnung und einem im Targetzentrum angeordneten Permanentmagneten, um einen gleichförmigeren Abtrag des Targetmaterials zu erreichen.

Es ist Aufgabe der vorliegenden Erfindung, eine Beschichtungsquelle für die physikalische Dampfphasenabscheidung und ein Verfahren zu deren Herstellung bereitzustellen, mit denen ein stabiler Beschichtungsprozess bei der Magnetron-Kathodenzerstäubung bzw. eine gute Kontrolle der Bogengeschwindigkeit bei der Lichtbogenverdampfung erreicht wird und dabei gleichzeitig eine möglichst gute thermische Ankopplung an eine gekühlte Auflage der Beschichtungsanlage, eine effiziente Herstellung der Beschichtungsquelle mit wenigen Arbeitsschritten, eine Anordnung ferromagnetischen Materials in nahezu beliebiger Geometrie räumlich nah an der aktiven Oberfläche eines Targets auch bei schwer oder nicht mechanisch bearbeitbaren Materialien ermöglicht ist und dabei das Risiko für die Einbringung von Verunreinigungen in die Beschichtungsanlage über die Beschichtungsquelle minimiert ist.

Diese Aufgabe wird mit einer Beschichtungsquelle für die physikalische Dampfphasenabscheidung nach Anspruch 1 gelöst. Vorteilhafte Weiterbildungen sind in den abhängigen Ansprüchen angegeben.

Die Beschichtungsquelle für die physikalische Dampfphasenabscheidung weist auf: zumindest ein, in einem pulvermetallurgischen Herstellungsprozess aus zumindest einem pulverförmigen Ausgangsmaterial gefertigtes Bauteil und zumindest einen in das Bauteil eingebetteten ferromagnetischen Bereich. Der zumindest eine ferromagnetische Bereich ist bei dem pulvermetallurgischen Herstellungsprozess in das Bauteil eingebracht und integriert, wobei der zumindest eine ferromagnetische Bereich zumindest einen permanentmagnetischen Bereich aufweist.

Es können dabei ein zusammenhängender oder mehrere ferromagnetische Bereiche vorgesehen sein. Unter ferromagnetisch wird dabei verstanden, dass dieser Bereich (bzw. diese Bereiche) eine magnetische Permeabilitätszahl >> 1 aufweisen. Der zumindest eine ferromagnetische Bereich kann dabei permanentmagnetisch ausgestaltet sein oder es können ein oder mehrere permanentmagnetische und/oder ein oder mehrere unmagnetisierte Bereiche vorgesehen sein. Der zumindest eine ferromagnetische Bereich kann dabei z.B. bei einem Herstellungsprozess für die Beschichtungsquelle pulverförmig eingebrachtes ferromagnetisches Pulver aufweisen. Der zumindest eine ferromagnetische Bereich kann dabei z.B. auch alternativ oder zusätzlich einen oder mehrere bei dem Herstellungsprozess eingebrachte makroskopische ferromagnetische Körper aufweisen. Das zumindest eine Bauteil der Beschichtungsquelle kann dabei z.B. durch das eigentliche Target, also das zu verdampfende Beschichtungsmaterial der Beschichtungsquelle gebildet sein. Das zumindest eine Bauteil kann aber z.B. auch durch eine fest mit dem Target verbundene Rückplatte aus einem anderen Material zur thermischen Ankopplung an eine gekühlte Auflage in einer Beschichtungsanlage gebildet sein. Bei einer Konfiguration der Beschichtungsquelle, bei der das eigentliche Target auf einer Halterung lösbar befestigt ist, die dazu ausgebildet ist, das Target mit einer gekühlten Auflage einer Beschichtungsanlage zu verbinden, kann das zumindest eine Bauteil z.B. auch durch die Halterung gebildet sein. Es können dabei z.B. sowohl in dem Target als auch in einer Rückplatte bzw. sowohl in dem Target als auch in der Halterung ferromagnetische Bereiche ausgebildet sein. In allen diesen Fällen ist der zumindest eine ferromagnetische Bereich derart angeordnet, dass er im Betrieb zwischen einer gekühlten Auflage der Beschichtungsanlage und der aktiven Oberfläche des Targets angeordnet ist. Aufgrund dieser Anordnung kann eine Magnetfeldgeometrie erzielt werden, die sehr nah an der aktiven Oberfläche des Targets wirksam wird, sodass im oberflächennahen Bereich des Targets eine hohe Magnetfelddichte bereitgestellt werden kann. Es wird somit ein von der verwendeten Beschichtungsanlage unabhängiges Magnetfeldsystem bereitgestellt, dass auf das jeweilige Beschichtungsmaterial und die zur Anwendung kommenden Prozesse abgestimmt und optimiert werden kann. Ferner können auf diese Weise gezielt definierte Bereiche der Oberfläche des Targets abgeschirmt werden. Es kann die Gefahr einer Überhitzung und einer daraus resultierenden erhöhten Emission von Spritzern des Beschichtungsmaterials bei einer Lichtbogenverdampfung vermieden werden.

In das Bauteil eingebettet bedeutet in diesem Zusammenhang fest mit dem Bauteil verbunden. Der zumindest eine ferromagnetische Bereich ist dabei bei dem pulvermetallurgischen Herstellungsprozess in das Bauteil eingebracht und fest mit dem Bauteil verbunden, d.h. bei dem pulvermetallurgischen Herstellungsprozess derart mitbearbeitet worden, dass er mit dem Rest des Bauteils unlösbar verbunden ist.

Da der ferromagnetische Bereich unmittelbar in dem Bauteil der Beschichtungsquelle eingebettet ist, befindet sich dieser im Betrieb der Beschichtungsquelle nahe an der aktiven Oberfläche des Targets und kann somit einen stabilen Beschichtungsprozess bei der Magnetron-Kathodenzerstäubung bzw. eine gute Kontrolle der Bogengeschwindigkeit bei der Lichtbogenverdampfung sicherstellen. Der zumindest eine ferromagnetische Bereich kann dabei zusammen mit dem Bauteil gepresst, geschmiedet, heißisostatisch gepresst, gewalzt, heißgepresst und/oder gesintert sein. Da der zumindest eine ferromagnetische Bereich bei dem pulvermetallurgischen Herstellungsprozess in das Bauteil eingebracht und durch diesen fest mit dem Bauteil verbunden ist, kann dieser ohne Spalten und Hohlräume mit dem Bauteil verbunden sein, sodass eine gute Wärmeleitfähigkeit zu einer gekühlten Auflage einer Beschichtungsanlage realisiert ist. Insbesondere kann in dieser Weise erreicht werden, dass keine, einen ungestörten Wärmestrom von der Targetoberfläche zu einer gekühlten Auflage behindernden Hohlräume in dem Bauteil gebildet sind. Ferner wird durch die Einbringung in dem pulvermetallurgischen Herstellungsprozess erreicht, dass ferromagnetische Bereiche mit beinahe beliebigen Geometrien eingebettet werden können und diese z.B. auch vollständig von dem Material des Bauteils umschlossen sein können. Das Einbringen in das Bauteil kann dabei unabhängig von dem Material des Bauteils erfolgen, sodass ein oder mehrere ferromagnetische Bereiche auch in Bauteilen angeordnet werden können, die sich nur schwer oder überhaupt nicht mechanisch nachbearbeiten lassen. Ferner kann die Beschichtungsquelle mit dem zumindest einen ferromagnetischen Bereich in zumindest einem Bauteil auch kostengünstig und mit wenigen Herstellungsschritten hergestellt werden, da nicht nach einer Herstellung des Bauteils mechanisch Ausnehmungen für einen ferromagnetischen Bereich gefertigt und der ferromagnetische Bereich in einem weiteren Schritt eingebracht werden müssen. Durch das Einbringen und Integrieren des zumindest einen ferromagnetischen Bereichs bei dem pulvermetallurgischen Herstellungsprozess kann die Beschichtungsquelle ferner in einer in sich geschlossenen Form bereitgestellt werden, bei der keine Hohlräume vorhanden sind, in der sich eventuell Verunreinigungen ansammeln können, die bei einem Beschichtungsprozess zu einer Verschlechterung des Vakuums oder unerwünschten Verunreinigungen der aufwachsenden Schicht führen können. Als ferromagnetische Materialien können insbesondere folgende Legierungen zum Einsatz kommen: NdFeB, SmCo, AlNiCo, SrFe, BaFe, Fe, Co und Ni.

Gemäß einer Ausgestaltung weist der zumindest eine ferromagnetische Bereich zumindest einen Bereich aus in dem pulvermetallurgischen Herstellungsprozess pulverförmig eingebrachtem ferromagnetischen Material auf. In diesem Fall können in einfacher Weise ferromagnetische Bereiche mit unterschiedlichsten Geometrien in dem Bauteil bereitgestellt werden. Ferner können z.B. mehrere ferromagnetische Bereiche mit unterschiedlichen Zusammensetzungen des ferromagnetischen Materials in einfacher Weise bereitgestellt werden, sodass das an der aktiven Oberfläche des Targets erzielte Magnetfeld gezielt geformt werden kann. Es kann z.B. in einfacher Weise auch zumindest ein ferromagnetischer Bereich mit positionsabhängiger Variation der Zusammensetzung des ferromagnetischen Materials bereitgestellt werden. Der zumindest eine ferromagnetische Bereich kann z.B. auch ausschließlich pulverförmig eingebrachtes ferromagnetisches Material aufweisen. In diesem Fall ist eine besonders einfache Herstellung ermöglicht. Gemäß der Erfindung weist der zumindest eine ferromagnetische Bereich zumindest einen permanentmagnetischen Bereich auf. Der permanentmagnetische Bereich kann dabei z.B. durch das Einbringen eines

zuvor magnetisierten makroskopischen Körpers gebildet sein oder es ist z.B. auch möglich, den in dem Bauteil eingebetteten Bereich bei der oder nach der Herstellung des Bauteils zu magnetisieren.

Gemäß einer Ausgestaltung weist der zumindest eine ferromagnetische Bereich zumindest einen, in dem pulvermetallurgischen Herstellungsprozess eingebrachten ferromagnetischen Körper auf. Durch die Einbringung eines oder mehrerer ferromagnetischer makroskopischer Körper kann das erzielte Magnetfeld sehr genau beeinflusst werden, insbesondere in dem Fall von magnetisierten (permanentmagnetischen) Körpern. Insbesondere können z.B. mehrere permanentmagnetische Körper mit unterschiedlicher Ausrichtung der Magnetisierung eingebracht werden.

Gemäß einer Ausgestaltung weist die Beschichtungsquelle ein Target auf und der zumindest eine ferromagnetische Bereich ist in dem Target angeordnet. Unter Target wird in diesem Zusammenhang der Bereich der Beschichtungsquelle verstanden, der aus dem als Beschichtungsmaterial dienenden Material gefertigt ist, das bei der Anwendung abgetragen wird. Bei dieser Ausgestaltung kann der zumindest eine ferromagnetische Bereich sehr nah an der aktiven Oberfläche des Targets bereitgestellt sein, sodass sich auch problematische Beschichtungsmaterialien kontrolliert verdampfen lassen. Diese Ausgestaltung kann insbesondere auch dort zum Einsatz kommen, wo das Target unmittelbar (ohne weitere Zwischenstrukturen) an eine gekühlte Auflage einer Beschichtungsanlage angekoppelt wird.

Gemäß einer Ausgestaltung weist die Beschichtungsquelle ein Target und eine mit dem Target fest verbundene Rückplatte zur thermischen Ankopplung an eine gekühlte Auflage einer Beschichtungsanlage auf und der zumindest eine ferromagnetische Bereich ist in dem Target und/oder der Rückplatte angeordnet. Bei einer derartigen Anordnung kann der zumindest eine ferromagnetische Bereich somit in dem Target, in der Rückplatte oder in beiden ausgebildet sein. Es können ferner sowohl in dem Target als auch in der Rückplatte verschiedene ferromagnetische Bereiche ausgebildet sein. Die Ausgestaltung mit einem Target und einer mit dem Target fest verbundenen Rückplatte kann insbesondere zur Anwendung kommen, wenn das Beschichtungsmaterial eine eher geringe thermische Leitfähigkeit aufweist und daher aufgrund resultierender Überhitzungsgefahr nicht als Target mit großer Dicke bereitgestellt werden kann, in der Beschichtungsanlage aber eine große Bauhöhe von einer gekühlten Auflage zu der aktiven Oberfläche des Targets erforderlich ist. Das Target und die Rückplatte können z.B. durch eine Herstellung in einem gemeinsamen pulvermetallurgischen Prozess aus unterschiedlichen Materialien gefertigt sein. Z.B. kann das Target aus TiAl mit gegebenenfalls weiteren Bestandteilen (insbesondere Cr, B, C oder Si) gebildet sein und die Rückplatte aus Al oder Cu. Die Materialien des Targets und der Rückplatte können dabei z.B. in dem Herstellungsprozess pulverförmig übereinander geschichtet und anschließend gemeinsam gepresst und/oder geschmiedet sein. Es ist z.B. aber auch möglich, dass das Target und die Rückplatte durch z.B. Bonden mit Indium oder in ähnlicher Weise fest miteinander verbunden sind.

Gemäß einer Ausgestaltung weist die Beschichtungsquelle ein Target und eine mit dem Target lösbar verbundene Halterung zur Verbindung des Targets mit einer gekühlten Auflage einer Beschichtungsanlage auf und der zumindest eine ferromagnetische Bereich ist in der Halterung angeordnet. Diese Anordnung kann z.B. zum Einsatz kommen, wenn nur relativ dünne Targets zweckmäßig sind, aber in einer Beschichtungsanlage eine relativ große Bauhöhe von einer gekühlten Auflage zu der aktiven Oberfläche des Targets realisiert werden muss. Das Target und die Halterung können dabei z.B. über eine mechanische Befestigung lösbar miteinander verbunden sein. Bei dieser Ausgestaltung kann das Magnetfeld durch die Anordnung des zumindest einen ferromagnetischen Bereichs in der Halterung wiederum anlagenunabhängig und targetspezifisch bereitgestellt werden. Dabei kann das austauschbare Target kostengünstig mit oder ohne ferromagnetische Bereiche bereitgestellt werden.

Gemäß einer Ausgestaltung ist die Beschichtungsquelle eine Magnetron-Kathodenzerstäubungs-Beschichtungsquelle. In diesem Fall kann der zumindest eine ferromagnetische Bereich in der Nähe der aktiven Oberfläche eines Targets dazu genutzt werden, den Sputterprozess an der aktiven Oberfläche gezielt zu kontrollieren.

Gemäß einer Ausgestaltung ist die Beschichtungsquelle eine Lichtbogenverdampfungs-Beschichtungsquelle. In diesem Fall kann der zumindest eine ferromagnetische Bereich in der Nähe der aktiven Oberfläche eines Targets dazu genutzt werden, die Bewegung des Lichtbogens an der Oberfläche zu kontrollieren. Es können Bewegungs- bzw. Ablationsmuster gezielt eingestellt werden, ein Kollabieren des Bogens in der Mitte der Beschichtungsquelle kann gezielt vermindert bzw. verhindert werden und es kann eine kontrollierte magnetisch induzierte Verdrängung des Bogens auf gewünschte Bereiche der Beschichtungsquelle bewirkt werden.

Die Aufgabe wird auch durch ein Verfahren zur Herstellung einer Beschichtungsquelle für die physikalische Dampfphasenabscheidung nach Anspruch 9 gelöst. Vorteilhafte Weiterbildungen sind in den abhängigen Ansprüchen angegeben.

Das Verfahren weist die Schritte auf: Einfüllen zumindest eines pulverförmigen Ausgangsmaterials für zumindest ein Bauteil der Beschichtungsquelle in eine Form; Einbringen zumindest eines permanentmagnetischen Körpers in die Form, sodass dieser in zumindest einem Bereich des pulverförmigen Ausgangsmaterials angeordnet wird; und Verpressen des derart gebildeten Bauteils. In dieser Weise werden die oben unter Bezug auf die Beschichtungsquelle beschriebenen Vorteile erzielt. Insbesondere können mit dem Verfahren ferromagnetische Bereiche in der Nähe einer aktiven Oberfläche eines Targets in einfacher Weise und mit wenigen Verfahrensschritten auch bei schwer oder nicht mechanisch bearbeitbaren Materialien realisiert werden. Es können somit ein oder mehrere ferromagnetische Bereiche in einfacher Weise und mit nahezu beliebiger Geometrie in das Material des Bauteils eingebettet werden und es ist auch in einfacher Weise möglich, diese Bereiche z.B. vollständig mit dem Material zu umschließen. Dies ist dabei bei verschiedensten Materialien möglich. Der oder die ferromagnetische Bereiche können dabei z.B. wieder in einem Target und/oder einer fest mit dem Target verbundenen Rückplatte und/oder einer Halterung angeordnet werden. Es ist dabei z.B. möglich, zuerst das pulverförmige Ausgangsmaterial für das Bauteil in die Form einzufüllen und anschließend das ferromagnetische Pulver bzw. den zumindest einen ferromagnetischen Körper. Es ist aber auch möglich, zuerst das ferromagnetische Pulver bzw. den zumindest einen ferromagnetischen Körper in die Form einzubringen und anschließend das pulverförmige Ausgangsmaterial. Zusätzlich zu dem Verpressen kann gegebenenfalls noch ein Umformen des gebildeten Bauteils erfolgen.

Gemäß einer Ausgestaltung erfolgt das Einbringen zumindest in einen Bereich des Ausgangsmaterials, der bei der Beschichtungsquelle ein Target bildet. Gemäß einer weiteren Ausgestaltung erfolgt das Einbringen zumindest in einen Bereich des Ausgangsmaterials, der bei der Beschichtungsquelle eine mit einem Target fest verbundene Rückplatte zur thermischen Ankopplung an eine gekühlte Auflage einer Beschichtungsanlage bildet. Gemäß einer weiteren Ausgestaltung erfolgt das Einbringen in einen Bereich des Ausgangsmaterials, der bei der Beschichtungsquelle eine mit einem Target lösbar verbundene Halterung zur Verbindung des Targets mit einer gekühlten Auflage einer Beschichtungsanlage bildet.

Weitere Vorteile und Weiterbildungen ergeben sich aus der nachfolgenden Beschreibung von Ausführungsbeispielen unter Bezugnahme auf die beigefügten Zeichnungen.
- Fig. 1: zeigt schematisch eine Beschichtungsquelle gemäß einer ersten Ausführungsform in Draufsicht
- Fig. 2: zeigt schematisch ein Beispiel einer Beschichtungsquelle gemäß der ersten Ausführungsform in einem seitlichen Schnitt
- Fig. 3: zeigt schematisch ein zweites Beispiel einer Beschichtungsquelle gemäß der ersten Ausführungsform in einem seitlichen Schnitt
- Fig. 4: zeigt schematisch ein drittes Beispiel einer Beschichtungsquelle gemäß der ersten Ausführungsform in einem seitlichen Schnitt
- Fig. 5: zeigt schematisch ein viertes Beispiel einer Beschichtungsquelle gemäß der ersten Ausführungsform in einem seitlichen Schnitt
- Fig. 6: zeigt schematisch ein erstes Beispiel einer Beschichtungsquelle gemäß einer zweiten Ausführungsform in einem seitlichen Schnitt
- Fig. 7: zeigt schematisch ein zweites Beispiel einer Beschichtungsquelle gemäß der zweiten Ausführungsform in einem seitlichen Schnitt
- Fig. 8: zeigt schematisch eine Beschichtungsquelle mit einem Target und einer Halterung in Draufsicht
- Fig. 9: zeigt schematisch eine Beschichtungsquelle mit Halterung in einem seitlichen Schnitt
- Fig. 10: zeigt schematisch eine weitere Beschichtungsquelle mit Halterung in einem seitlichen Schnitt
- Fig. 11: zeigt ein schematisches Blockdiagramm zur Erläuterung eines Herstellungsverfahrens einer Beschichtungsquelle

### Erste Ausführungsform

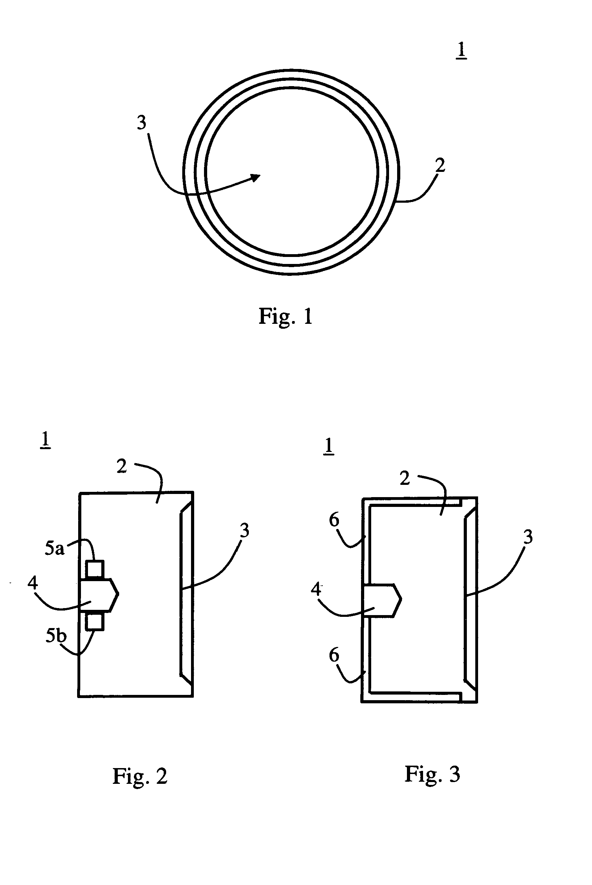

Eine erste Ausführungsform wird im Folgenden unter Bezugnahme auf die Fig. 1 bis Fig. 5 beschrieben. Bei der dargestellten Ausführungsform ist die Beschichtungsquelle -1- durch ein Target -2- für ein Verfahren der Lichtbogenverdampfung ausgebildet. Das Target -2- ist bei dieser Ausführungsform dazu ausgebildet, unmittelbar an einer gekühlten Auflage einer Beschichtungsanlage befestigt zu werden. Obwohl in Fig. 1 eine Beschichtungsquelle -1- mit einem kreisförmigen Querschnitt dargestellt ist, sind auch andere Formen, z.B. oval, rechteckig, etc. möglich. Dies gilt auch für die weiter unten beschriebenen weiteren Ausführungsformen und deren Modifikationen. Obwohl im Folgenden lediglich Ausführungsformen und Modifikationen beschrieben werden, bei denen die Beschichtungsquelle -1-jeweils für Lichtbogenverdampfung ausgebildet ist, ist es jeweils auch möglich, die Beschichtungsquelle für Magnetron-Kathodenzerstäubung (magnetron sputter deposition) auszubilden.

Das Target -2- weist eine aktive Oberfläche -3- auf, an der bei einem Beschichtungsprozess das Material des Targets -2- abgetragen wird. Bei der dargestellten Ausführungsform weist das Target -2- in der von der aktiven Oberfläche -3- abgewandten Rückseite eine Bohrung -4- zur Befestigung an einer gekühlten Auflage einer Beschichtungsanlage auf. Es ist jedoch auch möglich, eine andere Art der Befestigung an der gekühlten Auflage vorzusehen. Bei der in Fig. 2 dargestellten Ausführungsform ist die Beschichtungsquelle -1-vollständig durch das bei dem Beschichtungsverfahren zu verdampfende Beschichtungsmaterial gebildet, sodass das Target -2- das einzige Bauteil der Beschichtungsquelle -1- bildet. Das Target -2- ist dabei in einem pulvermetallurgischen Herstellungsprozess aus zumindest einem Ausgangsmaterial gebildet. Es kann z.B. aus einem pulverförmigen Ausgangsmaterial oder einer Mischung aus verschiedenen pulverförmigen Ausgangsmaterialien gebildet sein.

In dem Material des Targets -2- ist bei der ersten Ausführungsform zumindest ein ferromagnetischer Bereich eingebettet. Bei dem in Fig. 2 dargestellten Beispiel sind in dem Material des Targets -2- zwei ferromagnetische Bereiche -5a- und -5b- ausgebildet. Die ferromagnetischen Bereiche -5a- und -5b- sind dabei in dem Beispiel von Fig. 2 durch zwei makroskopische permanentmagnetische Körper gebildet, die in das Material des Targets -2-eingebettet sind. Die ferromagnetischen Bereiche -5a- und -5b- sind dabei bei dem pulvermetallurgischen Herstellungsprozess zur Herstellung des Targets -2-in das pulverförmige Ausgangsmaterial eingebracht und mit dem Material des Targets -2- verbunden worden. Sie sind dabei gemeinsam mit dem pulverförmigen Ausgangsmaterial verpresst und umgeformt worden, sodass diese unlösbar mit dem Material das Targets -2- verbunden sind. Obwohl in Fig. 2 beispielhaft zwei derartige Körper gezeigt sind, können auch lediglich ein solcher Körper oder mehr als zwei derartige Körper eingebracht sein. Die eingebrachten Körper können dabei beliebige andere Formen aufweisen.

Fig. 3 zeigt ein zweites Beispiel einer Beschichtungsquelle -1- gemäß der ersten Ausführungsform. Das zweite Beispiel unterscheidet sich von dem anhand von Fig. 2 beschriebenen Beispiel darin, dass der zumindest eine ferromagnetische Bereich -6- nicht durch eingebrachte makroskopische Körper gebildet ist, sondern durch in das Ausgangsmaterial des Targets -2-eingebrachtes ferromagnetisches Pulver. Das ferromagnetische Pulver ist dabei bei dem pulvermetallurgischen Herstellungsprozess zur Herstellung des Targets -2- in das pulverförmige Ausgangsmaterial eingebracht und wie bei dem ersten Beispiel durch gemeinsame Verarbeitung mit dem Material des Targets -2- verbunden. Obwohl in Fig. 3 eine bestimmte jochartige Form des ferromagnetischen Bereichs -6- dargestellt ist, sind auch viele andere Anordnungen möglich. Es können wiederum ein einziger ferromagnetischer Bereich -6- oder eine Mehrzahl von ferromagnetischen Bereichen ausgebildet sein.

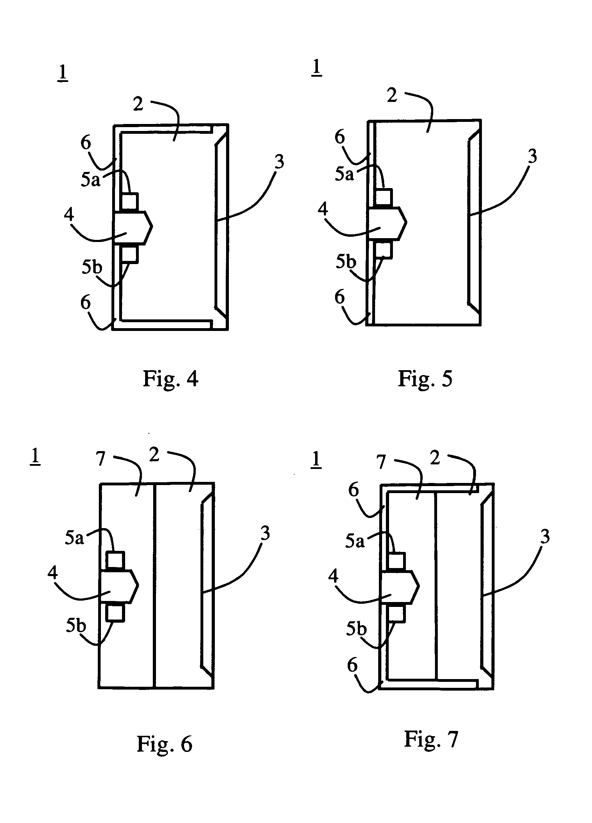

Fig. 4 zeigt ein drittes Beispiel einer Beschichtungsquelle -1- gemäß der ersten Ausführungsform. Bei dem dritten Beispiel sind dabei sowohl ferromagnetische Bereiche -5a- und -5b- vorgesehen, die durch eingebrachte makroskopische Körper gebildet sind, als auch ein ferromagnetischer Bereich -6-, der durch eingebrachtes ferromagnetisches Pulver gebildet ist. Es handelt sich somit um eine Kombination des ersten und des zweiten Beispiels. Fig. 5 zeigt ein weiteres Beispiel, das sich von dem in Fig. 4 dargestellten Beispiel durch die Form des durch ferromagnetisches Pulver gebildeten ferromagnetischen Bereichs -6- unterscheidet.

Bei der ersten Ausführungsform weist die Beschichtungsquelle -1- somit ein Target -2- auf, das dazu ausgebildet ist, unmittelbar mit einer zu kühlenden Auflage einer Beschichtungsanlage verbunden zu werden. In dem Target -2-sind dabei ein oder mehrere ferromagnetische Bereiche -5a-, -5b-, -6-ausgebildet, die jeweils durch bei dem pulvermetallurgischen Herstellungsprozess eingebrachte ferromagnetische Körper oder ferromagnetisches Pulver gebildet sind. Die ferromagnetischen Bereiche können dabei permanentmagnetisch ausgebildet sein, z.B. durch eingebrachte permanentmagnetische Körper oder durch Abkühlen des ferromagnetischen Pulvers unter die Curie-Temperatur in einem externen Magnetfeld.

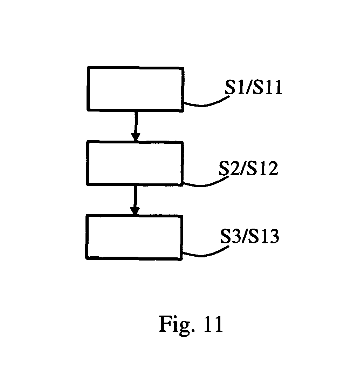

Ein Verfahren zur Herstellung einer Beschichtungsquelle -1- gemäß der ersten Ausführungsform wird im Folgenden unter Bezugnahme auf Fig. 11 beschrieben.

In einem Schritt -S1- wird pulverförmiges Ausgangsmaterial (ein oder mehrere Pulver) für das Target -2- in eine Form eingebracht. In einem Schritt -S2- wird der zumindest eine ferromagnetische Bereich -5a-, -5b- und/oder -6- in das pulverförmige Ausgangsmaterial eingebracht. Dies kann z.B. durch Einbringen zumindest eines makroskopischen ferromagnetischen Körpers oder durch Einbringen ferromagnetischen Pulvers erfolgen. In einem Schritt -S3- wird das pulverförmige Ausgangsmaterial gemeinsam mit dem eingebrachten ferromagnetischen Bereich verpresst und gegebenenfalls umgeformt. Dies kann z.B. durch Pressen unter hohem Druck in einer Presse und anschließendes Schmieden erfolgen. Es kann z.B. auch eine Verarbeitung durch Walzen, heißisostatisches Pressen (Hippen), Heißpressen, etc. erfolgen. Es ist zu beachten, dass die Verfahrensschritte -S1- und -S2- z.B. auch in umgekehrter Reihenfolge durchgeführt werden können.

Obwohl sich in den Fig. 2 bis 5 die ferromagnetischen Bereiche -5a-, -5b-, -6-jeweils an einem Rand des Materials des Targets -2- befinden, ist es z.B. auch möglich, diese allseits von dem Material des Targets -2- umschlossen auszubilden. Für den Fall, dass sowohl durch eingebrachtes ferromagnetisches Pulver gebildete ferromagnetische Bereiche als auch durch eingebrachte ferromagnetische Körper gebildete ferromagnetische Bereiche vorgesehen sind, können die durch eingebrachtes Pulver gebildeten Bereiche in beliebiger Anordnung zu den durch ferromagnetische Körper gebildeten Bereichen ausgebildet sein. Insbesondere können z.B. die durch eingebrachtes ferromagnetisches Pulver gebildeten Bereiche näher an der aktiven Oberfläche des Targets ausgebildet sein oder weiter von dieser entfernt als die durch eingebrachte ferromagnetische Körper gebildeten Bereiche.

### Zweite Ausführungsform

Eine zweite Ausführungsform wird nachfolgend unter Bezugnahme auf die Fig. 6 und Fig. 7 beschrieben. Dabei werden zur Vermeidung von Wiederholungen nur die Unterschiede zu der ersten Ausführungsform beschrieben und dieselben Bezugszeichen für die entsprechenden Komponenten verwendet.

Bei der zweiten Ausführungsform weist die Beschichtungsquelle -1- als Bauteile ein Target -2- mit einer aktiven Oberfläche -3- und eine unmittelbar mit dem Target -2- fest verbundene Rückplatte -7- auf. Die Rückplatte -7- ist dabei dazu ausgebildet, an einer gekühlten Auflage einer Beschichtungsanlage befestigt zu werden, was z.B. durch eine beispielhaft dargestellte Bohrung -4- erreicht werden kann. Die Rückplatte -7- ist dazu ausgebildet, eine gute thermische Ankopplung des Targets -2- an die gekühlte Auflage bereitzustellen, um eine gute Wärmeabführung von dem Target -2- zu gewährleisten. Bei dem Ausführungsbeispiel sind dabei sowohl das Target -2- als auch die Rückplatte -7- in einem gemeinsamen pulvermetallurgischen Herstellungsprozess aus pulverförmigen Ausgangsmaterialien gefertigt. Z.B. kann das Material des Targets -2- ein Beschichtungsmaterial mit geringer Wärmeleitfähigkeit sein, wie z.B. TiₓAl_{y} mit gegebenenfalls weiteren Komponenten, und das Material der Rückplatte -7- kann ein Material mit hoher Wärmeleitfähigkeit sein, wie z.B. Al oder Cu. Die feste Verbindung zwischen den beiden Bauteilen der Beschichtungsquelle -1-, dem Target -2- und der Rückplatte -7- kann dabei z.B. dadurch bewirkt sein, dass pulverförmiges Ausgangsmaterial für das Target -2- und pulverförmiges Ausgangsmaterial für die Rückplatte in einer gemeinsamen Form übereinander geschichtet und verpresst und anschließend gegebenenfalls geschmiedet, heißisostatisch gepresst, gewalzt, heißgepresst und/oder gesintert wurden.

Bei der zweiten Ausführungsform ist in das Target -2- und/oder die Rückplatte -7- zumindest ein ferromagnetischer Bereich eingebettet. Es können dabei in dem Target -2- ein oder mehrere ferromagnetische Bereiche ausgebildet sein, es können in der Rückplatte -7- ein oder mehrere ferromagnetische Bereiche ausgebildet sein, oder es können sowohl in dem Target -2- als auch in der Rückplatte -7- jeweils ein oder mehrere ferromagnetische Bereiche ausgebildet sein. Die einzelnen ferromagnetischen Bereiche können dabei wiederum z.B. durch eingebrachte makroskopische Körper oder durch eingebrachtes ferromagnetisches Pulver gebildet sein. Sie sind dabei gemeinsam mit dem pulverförmigen Ausgangsmaterial des Targets -2- und/oder der Rückplatte -7- verpresst und umgeformt worden, sodass diese unlösbar mit dem Material das Targets -2- und/oder der Rückplatte -7- verbunden sind. Ein oder mehrere der ferromagnetischen Bereiche können dabei wiederum permanentmagnetisch ausgebildet sein. Von diesen vielen verschiedenen möglichen Realisierungen werden im Folgenden zwei beispielhaft beschrieben.

Bei dem in Fig. 6 dargestellten Beispiel sind in die Rückplatte -7- zwei ferromagnetische Bereiche -5a- und -5b- eingebettet. Die beiden ferromagnetischen Bereiche -5a- und -5b- sind dabei durch makroskopische permanentmagnetische Körper gebildet, die in das Material der Rückplatte -7-bei dem pulvermetallurgischen Herstellungsprozess in das Ausgangsmaterial der Rückplatte -7- eingebracht und fest mit dem Material der Rückplatte -7-verbunden sind. Bei dem in Fig. 7 dargestellten Beispiel ist zusätzlich ein weiterer ferromagnetischer Bereich -6- in der Beschichtungsquelle -1-vorgesehen. Der ferromagnetische Bereich -6- ist dabei durch in dem pulvermetallurgischen Herstellungsprozess in das jeweilige pulverförmige Ausgangsmaterial des Targets -2- und der Rückplatte -7- eingebrachtes ferromagnetisches Pulver gebildet.

Ein Verfahren zur Herstellung einer Beschichtungsquelle gemäß der zweiten Ausführungsform wird im Folgenden unter Bezugnahme auf Fig. 11 kurz beschrieben.

In einem Schritt -S11- werden nacheinander pulverförmiges Ausgangsmaterial für das Target -2- und pulverförmiges Ausgangsmaterial für die Rückplatte -7- in eine Form eingefüllt. Dabei kann z.B. erst das Ausgangsmaterial für die Rückplatte -7- und anschließend das Ausgangsmaterial für das Target -2-eingefüllt werden oder umgekehrt. In einem Schritt -S12- wird der zumindest eine ferromagnetische Bereich -5a-, -5b- und/oder -6- durch Einbringen ferromagnetischen Pulvers und/oder zumindest eines ferromagnetischen Körpers in zumindest einen Bereich des pulverförmigen Ausgangsmaterials für das Target -2- und/oder die Rückplatte -7- gebildet. In einem anschließenden Schritt -S13- wird das pulverförmige Ausgangsmaterial gemeinsam mit dem eingebrachten ferromagnetischen Bereich verpresst und umgeformt. Auch in diesem Fall können die Schritte -S11- und -S12- z.B. wieder in umgekehrter Reihenfolge durchgeführt werden.

### Dritte Ausführungsform

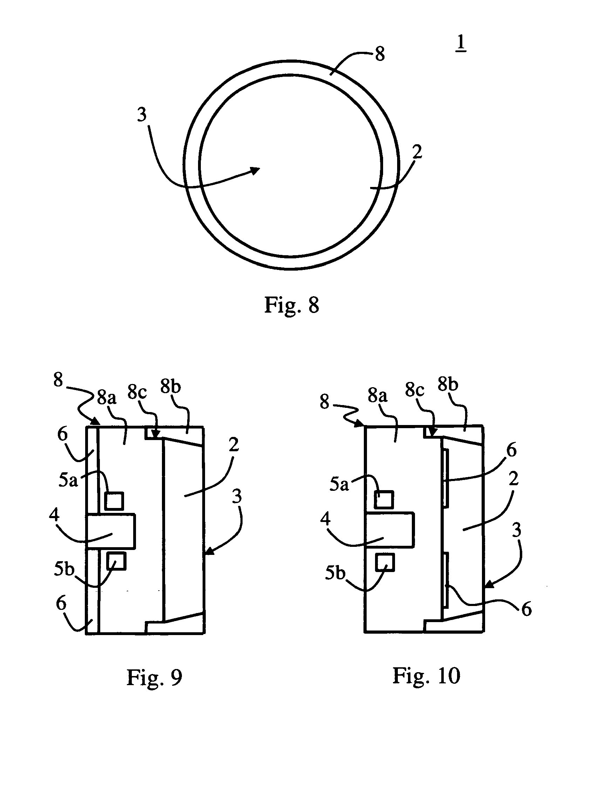

Eine dritte Ausführungsform wird im Folgenden unter Bezugnahme auf die Fig. 8 bis 10 beschrieben. Es werden wiederum nur die Unterschiede zu der ersten und der zweiten Ausführungsform beschrieben und es werden dieselben Bezugszeichen für entsprechende Komponenten verwendet.

Bei der dritten Ausführungsform weist die Beschichtungsquelle -1- als Bauteile ein Target -2- mit einer aktiven Oberfläche -3- und eine Halterung -8- für das Target -2- auf. Die Halterung -8- ist dabei dazu ausgebildet, dass Target -2-lösbar aufzunehmen und an einer gekühlten Auflage einer Beschichtungsanlage zu befestigen. Die Halterung -8- ist dabei dazu ausgebildet, eine gute thermische Ankopplung des Targets -2- an die gekühlte Auflage zu gewährleisten. Die Verbindung mit der gekühlten Auflage kann dabei z.B. wiederum durch eine beispielhaft dargestellte Bohrung -4- erreicht werden. Bei der in Fig. 9 dargestellten Ausführungsform weist die Halterung -8- ein erstes Halterungselement -8a- und ein zweites Halterungselement -8b- auf, die dazu ausgebildet sind, das Target -2- formschlüssig zu halten. Das erste Halterungselement -8a- und das zweite Halterungselement -8b- können dabei z.B. über ein Gewinde -8c- lösbar miteinander verbunden sein, um das Target -2- formschlüssig zu umgreifen.

Bei der dritten Ausführungsform ist in die Halterung -8- und oder das Target -2-zumindest ein ferromagnetischer Bereich eingebettet. Es können dabei in dem Target -2- ein oder mehrere ferromagnetische Bereiche ausgebildet sein, es können in der Halterung -8- ein oder mehrere ferromagnetische Bereiche ausgebildet sein, oder es können sowohl in dem Target -2- als auch in der Halterung -8- jeweils ein oder mehrere ferromagnetische Bereiche ausgebildet sein. Die einzelnen ferromagnetischen Bereiche können dabei wiederum z.B. durch eingebrachte makroskopische Körper oder durch eingebrachtes ferromagnetisches Pulver gebildet sein. Sie sind dabei gemeinsam mit dem pulverförmigen Ausgangsmaterial des Targets -2- und/oder pulverförmigem Ausgangsmaterial der Rückplatte -8- verpresst und umgeformt worden, so dass diese unlösbar mit dem Material des Targets -2- und/oder der Halterung -8-verbunden sind. Ein oder mehrere der ferromagnetischen Bereiche können dabei wiederum permanentmagnetisch ausgebildet sein. Von diesen vielen verschiedenen möglichen Realisierungen werden im Folgenden wiederum zwei beispielhaft beschrieben.

Bei dem in Fig. 9 dargestellten Beispiel sind in der Halterung -8- sowohl zwei ferromagnetische Bereiche -5a- und -5b-, die durch eingebettete makroskopische permanentmagnetische Körper gebildet sind, als auch ein ferromagnetischer Bereich -6-, der durch in dem pulvermetallurgischen Herstellungsprozess für die Halterung -8- pulverförmig eingebrachtes ferromagnetisches Pulver gebildet ist, vorgesehen. Bei diesem Beispiel ist in dem Target -2- kein ferromagnetischer Bereich vorgesehen. Bei dem in Fig. 10 dargestellten weiteren Beispiel sind in der Halterung -8- zwei ferromagnetische Bereiche -5a- und -5b-, die durch eingebettete makroskopische permanentmagnetische Körper gebildet sind, vorgesehen und in dem Target -2-ist ein weiterer ferromagnetischer Bereich -6- vorgesehen, der durch in dem pulvermetallurgischen Herstellungsprozess für das Target -2- pulverförmig eingebrachtes ferromagnetisches Pulver gebildet ist.

Bei einem Herstellungsverfahren für eine Beschichtungsquelle -1- wird in einem Schritt pulverförmiges Ausgangsmaterial für die Halterung -8- und/oder das Target -2- in eine Form eingefüllt. In einem weiteren Schritt wird der zumindest eine ferromagnetische Bereich -5a-, -5b- und/oder -6- durch Einbringen ferromagnetischen Pulvers und/oder zumindest eines ferromagnetischen Körpers in zumindest einen Bereich des pulverförmigen Ausgangsmaterials gebildet. In einem anschließenden Schritt wird das pulverförmige Ausgangsmaterial gemeinsam mit dem eingebrachten ferromagnetischen Bereich verpresst und umgeformt.

Es wurden somit Ausführungsformen beschrieben, mit denen es jeweils ermöglicht ist, eine sehr hohe Magnetfelddichte an der Oberfläche des Targets einer Beschichtungsquelle bereitzustellen. Bei einer Lichtbogenverdampfung werden in dieser Weise die Zündeigenschaften und die Stabilität des Bogens während eines Beschichtungsprozesses wesentlich verbessert. Bei metallischen Targets wird in dieser Weise eine Reduktion der Emission von Spritzern und Tröpfchen erreicht. Bei Targets aus metallkeramischem Material bzw. keramischem Material werden aufgrund der höheren erzielten Geschwindigkeit in der Bewegung des Lichtbogens und der Möglichkeit, die Bewegung und damit den Abtrag des Beschichtungsmaterials in gewünschte Bahnen zu lenken, der lokale Energieeintrag im Spot verringert und Nachteile aufgrund von niedriger elektrischer Leitfähigkeit und niedriger Thermoschockbeständigkeit des Targetmaterials kompensiert. Die eingebrachten ferromagnetischen bzw. magnetischen Komponenten können dabei derart angeordnet werden, dass der Abtragvorgang bzw. das Abtragprofil des Beschichtungsmaterials gesteuert werden können. Mit den beschriebenen Anordnungen wird ferner auch eine direkte Abscheidung ferromagnetischer Beschichtungsmaterialien mittels Lichtbogenverdampfung ermöglicht.

Der oder die magnetischen Bereiche können z.B. darauf optimiert werden, dass im Zusammenspiel mit in der Beschichtungsanlage vorgesehenen externen Magnetfeldern im oberflächennahen Bereich des Targets die gewünschten Magnetfelder mit hoher Genauigkeit eingestellt werden. Es kann dabei eine gezielte Schwächung und/oder Verstärkung anlagenseitiger Magnetfelder mit lokaler Auflösung bereitgestellt werden. Die magnetischen Bereiche können dabei z.B. auch derart ausgebildet werden, dass bestimmte Bereiche für den Beschichtungsprozess abgeschirmt werden, sodass dort kein nennenswerter Abtrag stattfindet. Ferner können durch die beschriebene Ausgestaltung bestimmte Bereiche des Targets vor Vergiftung geschützt werden, indem z.B. durch gezielte Gestaltung der resultierenden Magnetfelder eine unerwünschte Beschichtung des Targets mit z.B. keramischen Nitrid- oder Oxidschichten vermieden wird. Bei einer Beschichtungsquelle für einen Lichtbogenverdampfungsprozess können die Bewegungsbahnen des Bogens an der aktiven Oberfläche des Targets vorgegeben werden. Dies ermöglicht z.B. die Verwendung segmentierter Targets, die in verschiedenen Bereichen unterschiedliche Materialzusammensetzungen aufweisen, zum Abscheiden von Schichten mit gewünschter chemischer Zusammensetzung.

Die Ausgestaltung der Beschichtungsquelle mit Target und fest verbundener Rückplatte bzw. mit Target und Halterung kann insbesondere auch dann zum Einsatz kommen, wenn das Target aus einem nicht oder nur sehr schwierig zu zerspanenden Material, z.B. aus einer Keramik besteht, sodass ein nachträgliches Einbringen von Gewindebohrungen oder Klemmstufen in das Targetmaterial nicht möglich ist.

## Patentansprüche

1. Beschichtungsquelle (1) für die physikalische Dampfphasenabscheidung, mit
zumindest einem, in einem pulvermetallurgischen Herstellungsprozess aus zumindest einem pulverförmigen Ausgangsmaterial gefertigten Bauteil (2; 7; 8), und
zumindest einem in das Bauteil eingebetteten ferromagnetischen Bereich (5a, 5b, 6),
wobei der zumindest eine ferromagnetische Bereich (5a, 5b, 6) bei dem pulvermetallurgischen Herstellungsprozess in das Bauteil (2; 7; 8) eingebracht und fest mit dem Bauteil verbunden ist.
**dadurch gekennzeichnet, dass** der zumindest eine ferromagnetische Bereich (5a, 5b, 6) zumindest einen permanentmagnetischen Bereich aufweist.

2. Beschichtungsquelle nach Anspruch 1, **dadurch gekennzeichnet, dass** der zumindest eine ferromagnetische Bereich (5a, 5b, 6) zumindest einen Bereich (6) aus in dem pulvermetallurgischen Herstellungsprozess pulverförmig eingebrachtem ferromagnetischen Material aufweist.

3. Beschichtungsquelle nach einem der vorangehenden Ansprüche,
**dadurch gekennzeichnet, dass** der zumindest eine ferromagnetische Bereich (5a, 5b, 6) zumindest einen, in dem pulvermetallurgischen Herstellungsprozess eingebrachten ferromagnetischen Körper (5a, 5b) aufweist.

4. Beschichtungsquelle nach einem der vorangehenden Ansprüche,
**dadurch gekennzeichnet, dass** die Beschichtungsquelle (1) ein Target (2) aufweist und der zumindest eine ferromagnetische Bereich (5a, 5b, 6) in dem Target angeordnet ist.

5. Beschichtungsquelle nach einem der vorangehenden Ansprüche,
**dadurch gekennzeichnet, dass** die Beschichtungsquelle (1) ein Target (2) und eine mit dem Target fest verbundene Rückplatte (7) zur thermischen Ankopplung an eine gekühlte Auflage einer Beschichtungsanlage aufweist und der zumindest eine ferromagnetische Bereich (5a, 5b, 6) in dem Target (2) und/oder der Rückplatte (7) angeordnet ist.

6. Beschichtungsquelle nach einem der Ansprüche 1 bis 4,
**dadurch gekennzeichnet, dass** die Beschichtungsquelle (1) ein Target (2) und eine mit dem Target lösbar verbundene Halterung (8) zur Verbindung des Targets mit einer gekühlten Auflage einer Beschichtungsanlage aufweist und der zumindest eine ferromagnetische Bereich (5a, 5b, 6) in der Halterung (8) angeordnet ist.

7. Beschichtungsquelle nach einem der vorangehenden Ansprüche,
**dadurch gekennzeichnet, dass** die Beschichtungsquelle (1) eine Magnetron-Kathodenzerstäubungs-Beschichtungsquelle ist.

8. Beschichtungsquelle nach einem der der Ansprüche 1 bis 6,
**dadurch gekennzeichnet, dass** die Beschichtungsquelle (1) eine Lichtbogenverdampfungs-Beschichtungsquelle ist.

9. Verfahren zur Herstellung einer Beschichtungsquelle (1) für die physikalische Dampfphasenabscheidung mit den Schritten:
Einfüllen zumindest eines pulverförmigen Ausgangsmaterials für zumindest ein Bauteil (2; 7; 8) der Beschichtungsquelle in eine Form;
Einbringen zumindest eines permanentmagnetischen Körpers (5a, 5b) in die Form, sodass dieser in zumindest einem Bereich des pulverförmigen Ausgangsmaterials angeordnet wird; und
Verpressen des derart gebildeten Bauteils.

10. Verfahren nach Anspruch 9, **dadurch gekennzeichnet, dass** das Einbringen zumindest in einen Bereich des Ausgangsmaterials erfolgt, der bei der Beschichtungsquelle (1) ein Target (2) bildet.

11. Verfahren nach Anspruch 9 oder 10, **dadurch gekennzeichnet, dass** das Einbringen zumindest in einen Bereich des Ausgangsmaterials erfolgt, der bei der Beschichtungsquelle (1) eine mit einem Target (2) fest verbundene Rückplatte (7) zur thermischen Ankopplung an eine gekühlte Auflage einer Beschichtungsanlage bildet.

12. Verfahren nach einem der Ansprüche 9 oder 10,
**dadurch gekennzeichnet, dass** das Einbringen in einen Bereich des Ausgangsmaterials erfolgt, der bei der Beschichtungsquelle (1) eine mit einem Target (2) lösbar verbundene Halterung (8) zur Verbindung des Targets (2) mit einer gekühlten Auflage einer Beschichtungsanlage bildet.

## Claims

1. A coating source (1) for physical vapor deposition, having
at least one component (2; 7; 8) manufactured in a powder-metallurgical production process from at least one pulverulent starting material, and
at least one ferromagnetic region (5a, 5b, 6) embedded in the component, wherein the at least one ferromagnetic region (5a, 5b, 6) is introduced into the component (2; 7; 8) and is fixedly connected to the component in the powder-metallurgical production process **characterized in that** the at least one ferromagnetic region (5a, 5b, 6) comprises at least one permanent-magnetic region.

2. The coating source as claimed in claim 1, **characterized in that** the at least one ferromagnetic region (5a, 5b, 6) has at least one region (6) made of ferromagnetic material introduced in powder form in the powder-metallurgical production process.

3. The coating source as claimed in one of the preceding claims, **characterized in that** the at least one ferromagnetic region (5a, 5b, 6) comprises at least one ferromagnetic body (5a, 5b) introduced in the powder-metallurgical production process.

4. The coating source as claimed in one of the preceding claims, **characterized in that** the coating source (1) comprises a target (2) and the at least one ferromagnetic region (5a, 5b, 6) is arranged in the target.

5. The coating source as claimed in one of the preceding claims, **characterized in that** the coating source (1) comprises a target (2) and a back plate (7), which is fixedly connected to the target, for thermal coupling to a cooled support of a coating facility, and the at least one ferromagnetic region (5a, 5b, 6) is arranged in the target (2) and/or the back plate (7).

6. The coating source as claimed in one of claims 1 to 4, **characterized in that** the coating source (1) comprises a target (2) and a mount (8), which is removably connected to the target, for connecting the target to a cooled support of a coating facility, and the at least one ferromagnetic region (5a, 5b, 6) is arranged in the mount (8).

7. The coating source as claimed in one of the preceding claims, **characterized in that** the coating source (1) is a magnetron sputter deposition coating source.

8. The coating source as claimed in one of claims 1 to 6, **characterized in that** the coating source (1) is a cathodic arc deposition coating source.

9. A method for producing a coating source (1) for physical vapor deposition having the following steps:
placing at least one pulverulent starting material for at least one component (2; 7; 8) of the coating source into a mold;
introducing at least one permanent-magnetic body (5a, 5b) into the mold, so that it becomes arranged in at least one region of the pulverulent starting material; and
compacting the component thus formed.

10. The method as claimed in claim 9, **characterized in that** the introduction is performed at least in one region of the starting material, which forms a target (2) in the coating source (1).

11. The method as claimed in claim 9 or 10, **characterized in that** the introduction is performed at least in one region of the starting material which, in the coating source (1), forms a back plate (7) fixedly connected to a target (2), for thermal coupling to a cooled support of a coating facility.

12. The method as claimed in one of claims 9 or 10, **characterized in that** the introduction is performed in a region of the starting material which, in the coating source (1), forms a mount (8), which is removably connected to a target (2), for connecting the target (2) to a cooled support of a coating facility.

## Revendications

1. Source de revêtement (1) pour le dépôt physique en phase vapeur comprenant, premièrement, au moins un élément structurel (2 ; 7 ; 8) réalisé par métallurgie des poudres à partir d'au moins un matériau pulvérulent et, deuxièmement, au moins une zone ferromagnétique (5a, 5b, 6) intégrée dans l'élément structurel, dans laquelle ladite zone ferromagnétique (5a, 5b,6) au moins unique est incorporée, au cours du processus de métallurgie des poudres, dans l'élément structurel (2 ; 7 ; 8) et jointe à demeure à ce dernier, **caractérisée en ce que** ladite zone ferromagnétique (5a, 5b,6) au moins unique inclut au moins un secteur à magnétisation permanente.

2. Source de revêtement selon la revendication 1, **caractérisée en ce que** la zone ferromagnétique (5a, 5b, 6) au moins unique inclut au moins un secteur (6) réalisé en un matériau ferromagnétique et incorporé sous forme pulvérulente au cours du processus de métallurgie des poudres.

3. Source de revêtement selon l'une quelconque des revendications précédentes, **caractérisée en ce que** la zone ferromagnétique (5a, 5b, 6) au moins unique inclut au moins un corps ferromagnétique (5a, 5b) incorporé au cours du processus de métallurgie des poudres.

4. Source de revêtement selon l'une quelconque des revendications précédentes, **caractérisée en ce que** ladite source (1) comprend une cible (2) et **en ce que** la zone ferromagnétique (5a, 5b, 6) au moins unique est agencée dans la cible.

5. Source de revêtement selon l'une quelconque des revendications précédentes, **caractérisée en ce que** ladite source (1) comprend une cible (2) et une plaque arrière (7) jointe à demeure à la cible pour assurer le couplage thermique avec un support réfrigéré d'une installation de revêtement et **en ce que** la zone ferromagnétique (5a, 5b, 6) au moins unique est agencée dans la cible (2) et/ou dans la plaque arrière (7).

6. Source de revêtement selon l'une quelconque des revendications 1 à 4, **caractérisée en ce que** ladite source (1) possède une cible (2) et un dispositif de fixation (8) joint amovible à la cible, ce dernier étant destiné à relier la cible à un support réfrigéré d'une installation de revêtement et **en ce que** la zone ferromagnétique (5a, 5b, 6) au moins unique est agencée dans le dispositif de fixation (8).

7. Source de revêtement selon l'une quelconque des revendications précédentes, **caractérisée en ce qu'**il s'agit d'une source de revêtement à pulvérisation cathodique par magnétron.

8. Source de revêtement selon l'une quelconque des revendications 1 à 6, **caractérisée en ce qu'**il s'agit d'une source de revêtement à évaporation par arc.

9. Procédé de fabrication d'une source de revêtement (1) pour le dépôt physique en phase vapeur comprenant les étapes suivantes :
Versement dans un moule d'au moins un matériau de départ pulvérulent pour au moins un élément structurel (2 ; 7 ; 8) de la source de revêtement ; incorporation dans le moule d'au moins un corps à magnétisation permanente (5a, 5b), de façon telle que ce dernier est disposé dans au moins un secteur du matériau de départ pulvérulent ; et pressage de l'élément structurel réalisé de la sorte.

10. Procédé selon la revendication 9, **caractérisé en ce que** ladite incorporation est effectuée au moins dans un secteur du matériau de départ qui forme une cible (2) dans la source de revêtement (1).

11. Procédé selon la revendication 9 ou 10, **caractérisé en ce que** ladite incorporation est effectuée au moins dans un secteur du matériau de départ qui, dans la source de revêtement (1), forme une plaque arrière (7) reliée à demeure à la cible (2) pour assurer le couplage thermique avec un support réfrigéré d'une installation de revêtement.

12. Procédé selon la revendication 9 ou 10, **caractérisé en ce que** ladite incorporation est effectuée au moins dans un, secteur du matériau de départ qui, dans la source de revêtement (1 ), forme un dispositif de fixation joint amovible à la cible (2) afin de relier cette dernière à un support réfrigéré d'une installation de revêtement.
